# EUROPEAN PATENT APPLICATION

(11) **EP 2 296 285 A1**
(43) Date of publication of application: **16.03.2011**
(21) Application number: 09305839.4
(22) Date of filing: 14.09.2009
(51) Int. Cl.: H04B 1/10, H03G 3/30

(54) **Device for processing band-restricted radio frequency signals, system and method thereof**

(71) Applicant: Alcatel Lucent, 75008 Paris (FR)
(72) Inventor: Bouet, Céline, 92400, Courbevois (FR); Le Bihan, Christelle, 92250, La Garenne Colombes (FR); Perney, Olivier, 95100, Argenteuil (FR); De Abreu, Pedro, 94200, Ivry sur Seine (FR); Schroeder, Axel, 31717, Nordsehl (DE)
(74) Representative: Wetzel, Emmanuelle

(57) **Abstract**

The invention relates to a device (DEVI) for processing band-restricted radio frequency signals comprising an input (IN) for the radio frequency signals (RFS_DEV_IN) and of least one filter (IFF, DCF) for filtering the radio frequency signals (RFS_FIL_IN1, RFS_FIL_IN2), wherein the device (DEV1) further comprises at least one measuring unit (PD) for measuring of least one power level of the radio frequency signals between the input (IN) and the at least one filter (IFF, DCF) and comprises a first controlling unit (C) for controlling at least one first component of the device (DEVI) between the input (IN) and the al least one filter (IFF, DCF) depending on the at least one power level. The invention further relates to a receiver comprising the device, to a system comprising the device, and to a method for processing radio frequency signals.

## Description

### FIELD OF THE INVENTION

The invention relates to a device for processing band-restricted radio frequency signals according to the preamble of claim 1, to a receiver comprising the device, to a system comprising the device, and to a method for processing the radio frequency signals according to the preamble of claim 15.

### BACKGROUND

In radio receivers such as superheterodyne radio receivers, transfer functions of functional units such as a gain function of an LNA (LNA = low-noise amplifier) or a conversion function of an A/D converter (A/D = analogue-to-digital) have linear ranges up to maximum input power thresholds. Above the maximum input power thresholds limiting effects such as saturation effects occur.

In modern radio receiver architectures, the functional units are often integrated into a single chip, which minimises costs in comparison to discrete solutions and which makes compromises according to sizes of the linear ranges. Therefore, such radio receiver architectures are not protected against any kind of interferers with power levels above the maximum input power thresholds and with frequency components passing a band-pass filter located in front of an input of the radio receiver.

Interferers may result from emitters such as base stations or mobile stations working with a different mobile radio standard (e.g. a GSM interferer operates in a CDMA 2000 frequency band) in comparison to a mobile radio standard used by the radio receiver or may result from emitters working with a same mobile radio standard (e.g. a UMTS interferer results from a mobile station, that transmits at maximum output power trying to establish a radio link to a Node B base station) like the radio receiver.

An interferer protection of the A/D converter, which is located between an RF front end and a digital baseband board, can be done by using on AGC circuit (AGC = automatic gain control), which controls for example a gain of the LNA. The AGC circuit measures a power level of a radio frequency signal in a digital domain being filtered by a channel filter, which selects a specific channel of a pass-band of the band-pass filter. Depending on an overstepping of an AGC threshold by the power level of the filtered radio frequency signal, the gain of the LNA is controlled. Thereby, an output power level of the LNA can be kept below a maximum input power threshold of the A/D converter. Above the maximum input power threshold, analogue input power levels are converted to a same digital output power level.

In case of in-band interferers with frequency components outside a pass-band of the channel filter of e.g. 5 MHz and inside the pass-band of the band-pass filter of e.g. 50 MHz, the LNA and/or further components such as a mixer of the radio receiver being located between the band-pass filter and the channel filter cannot be protected by the AGC circuit against saturation, because such in-band interferers are blocked by the channel filter and therefore cannot be measured by the AGC circuit. From this it follows, that power levels of the in-band interferers are processed by the LNA and/or the further components but will not be processed by components subsequent to on output of the channel filter. The power levels of the in-band interferers add up to an overall input power level of the LNA and/or the further components, which may exceed the maximum input power thresholds of the LNA and/or the further components and may drive the LNA and/or the further components into saturation.

The way of processing band-restricted radio frequency signals in a radio receiver affects an assembly of the radio receiver and affects performances of the radio receiver and of a system comprising the radio receiver such as a reception quality of the radio frequency signals.

Therefore, it is an object of the invention to provide an improved radio receiver assembly for preventing limiting effects of the LNA and/or the further components of the radio receiver by in-band interferers and a degradation of on overall performance of the system.

### SUMMARY

The object is achieved by a device for processing radio frequency signals comprising an input for the radio frequency signals and at least one filter for filtering the radio frequency signals, wherein the device further comprises at least one measuring unit for measuring at least one power level of the radio frequency signals between the input and the at least one filter, and a first controlling unit for controlling at least one component of the device between the input and the at least one filter depending on the at least one power level.

The object is further achieved by a receiver comprising the device, by a system comprising the device, and by a method for processing radio frequency signals according to an independent claim 15.

The invention provides an advantage of avoiding saturation effect or limiting effects at one or more components of the device being located between the input of the device and the at least one filter in case of in-band interferers with frequency components being located outside a frequency band of the at least one filter but inside a frequency band being applied to the input of the device. Furthermore, a degradation of signal quality of the radio frequency signals being processed by the device can be prevented by avoiding the saturation effect or the limiting effect.

In an improved embodiment of the invention, the first controlling unit for controlling the at least one first component of the device further depends on a power level of filtered radio frequency signals.

This provides a further benefit of optimizing a power level of the filtered radio frequency signals to dynamic ranges of components subsequent to the at least one filter.

In a further embodiment of the invention, the device further comprises at least one second controlling unit for controlling at least one second component of the device.

The further embodiment provides a benefit of independently controlling different components of the device and thereby adapting power levels of the radio frequency signals independently to different dynamic ranges of the different components.

In an even further embodiment of the invention, the at least one second controlling unit for controlling the at least one second component of the device comprises an automatic gain control depending on a power level of filtered radio frequency signals.

The even further embodiment of the invention provides the benefit of independently adjusting a power level of the radio frequency signals by the first controlling unit for controlling the at least one first component of the device between the input and the at least one filter in case of the in-band interferers and adjusting a power level of the filtered radio frequency signals to dynamic ranges of components subsequent to the means for filtering the radio frequency signals by the automatic gain control. According to two further embodiments of the invention, the first controlling unit for controlling the at least one first component of the device adjusts an input power level of an amplifier or a gain of the amplifier.

The two further embodiments of the invention allow avoiding saturation effects within the amplifier or limiting effects within components located subsequent to the amplifier in a propagation path of the radio frequency signals.

According to two even further embodiments of the invention, the first controlling unit for controlling the at least one first component of the device may adjust an input power level of a mixer or a gain of the mixer. The two even further embodiments of the invention allow avoiding saturation effects within the mixer or limiting effects within components located subsequent to the mixer in the propagation path of the radio frequency signals.

In another embodiment of the invention, the first controlling unit for controlling the at least one first component of the device comprises an analogue data comparison.

This provides the possibility of using of an analogue interferer protection control circuit, if the at least one first component of the device may comprise for example an analogue control input.

In yet another embodiment of the invention, the first controlling unit for controlling the at least one first component of the device comprises a digital data comparison.

The yet another embodiment provides the possibility of using a digital interferer protection control circuit, if the at least one first component of the device may comprise for example a digital control input. Furthermore, the digital data comparison is easier to change and easier to optimize by changing for example simply a digital threshold value or by updating a software product with advanced functions such as averaging.

According to a further embodiment of the invention, a receiver such as used in a repeater or a remote unit comprises the device. This provides the possibility of improving a reception quality of radio frequency signals in the receiver in case of the in-band interferers.

According to an even further embodiment of the invention, a system such as an in-building radio communication system comprises the receiver.

This provides the benefit of improving operation parameters of the system such as lower blocking cases, higher data rates, etc. in case of the in-band interferes.

Further advantageous features of the invention are defined by further dependent claims for the device and are described in the following detailed description of the invention.

### BRIEF DESCRIPTION OF THE FIGURES

The embodiments of the invention will become apparent in the following detailed description and will be illustrated by accompanying figures given by way of non-limiting illustrations.
Figure 1 shows schematically a block diagram of a device, an antenna system and a duplexer according to a first and a second embodiment of the invention.
Figure 2 shows schematically a block diagram of an analogue processing unit according to the first embodiment of the invention.
Figure 3 shows schematically a block diagram of an analogue processing unit according to the second embodiment of the invention.
Figure 4 shows schematically a block diagram of a method according to embodiments of the invention.
Figure 5 shows schematically a block diagram of a device, an antenna system and a duplexer according to a third, a fourth, a fifth, and a sixth embodiment of the invention.
Figure 6 shows schematically a block diagram of an analogue processing unit according to the third embodiment of the invention.
Figure 7 shows schematically a block diagram of an analogue processing unit according to the fourth embodiment of the invention.
Figure 8 shows schematically a block diagram of an analogue processing unit according to the fifth embodiment of the invention.
Figure 9 shows schematically a block diagram of an analogue processing unit according to the sixth embodiment of the invention.
Figure 10 shows schematically a block diagram of a device, an antenna system and a duplexer according to a seventh embodiment of the invention.
Figure 11 shows schematically a block diagram of an analogue processing unit according to the seventh embodiment of the invention.
Figure 12 shows schematically a block diagram of an analogue processing unit according to an eighth embodiment of the invention.
Figure 13 shows schematically a block diagram of a radio communication system according to an application of the embodiments of the invention.

### DESCRIPTION OF THE EMBODIMENTS

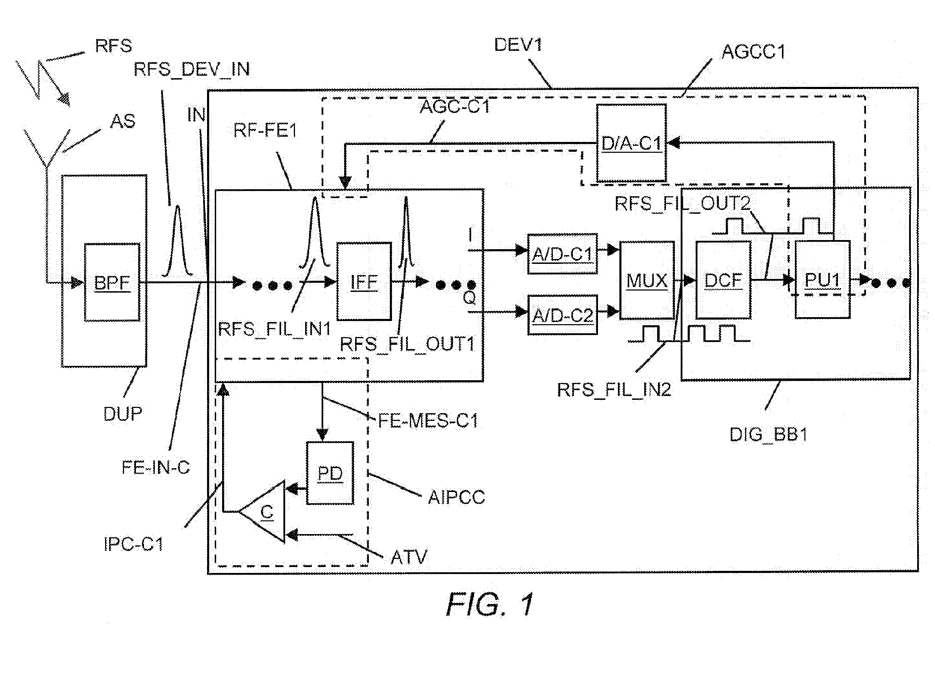

Figure 1 shows schematically in a block diagram a device DEV1, an antenna system AS, and a duplexer DUP according to a first and a second embodiment of the invention.

The device DEV1 may be for example a radio receiver of a mobile station or of a base station. In further alternatives, the device DEV1 may be a repeater to be used in a wireless or wireline communication system or a remote unit such as used in an in-building radio communication system. In even further alternatives, the device DEV1 may be for example an AM radio receiver (AM = amplitude modulation), a radar receiver, or a high fidelity audio amplifier, if power levels of high in-band interferers will appear in such devices and will otherwise degrade a performance of such devices. Depending on the above mentioned alternatives, the antenna system AS and/or the duplexer may be needed or may be not needed for a reception and pre-processing of radio frequency signals RFS. For example, instead of the antenna system AS and the duplexer DUP a wireline transmission line is used at an input IN of the device DEV1 for applying radio frequency signals RFS_DEV_IN to the input IN.

The duplexer DUP may comprise a band-pass filter BPF for selecting an RF band of the received radio frequency signals RFS.

The device DEV1 may comprise an analogue processing unit RF-FE1 such as an RF front-end, two analogue-to-digital converters A/D-C1, A/D-C2, a digital multiplexer MUX, a digital processing unit DIG-BB1 such as a digital baseband board, an automatic gain control circuit AGCC1, and on analogue interferer protection control circuit AIPCC. Further components of the device DEV1 are not shown for simplification.

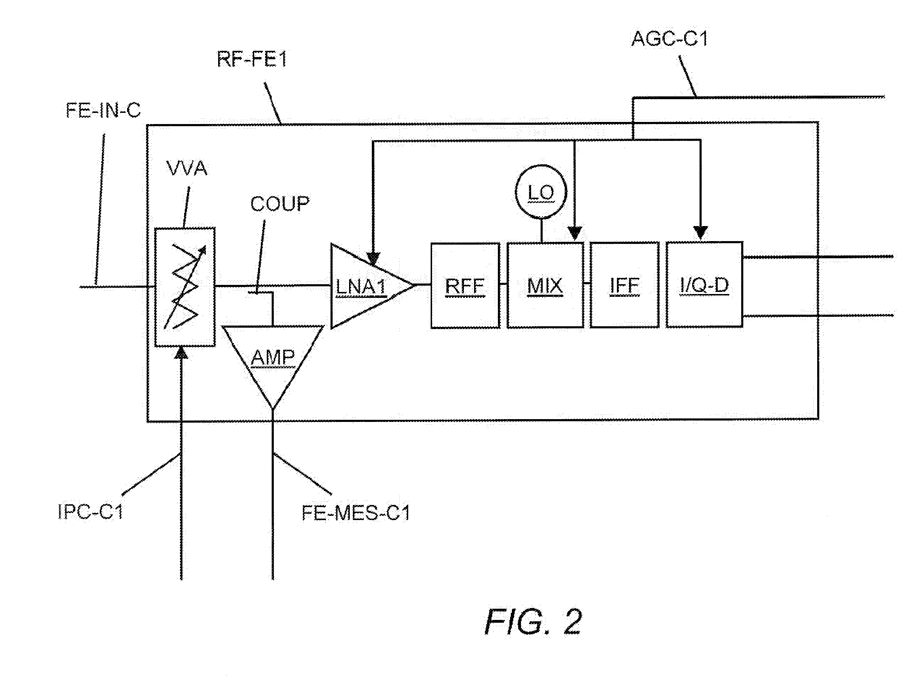

In an alternative, the device DEV1 may comprise instead of the two analogue-to-digital converters A/D-C1, A/D-C2, the digital multiplexer MUX, the automatic gain control circuit AGCC1, and the digital processing unit DIG_BB1 a further analogue processing unit such as a transmitter and a further antenna system such as used in a repeater. The analogue processing unit RF-FE1 may comprise a filter IFF such as an analogue channel filter. Further components of the analogue processing unit RF-FE1 such as being used in a superheterodyne radio receiver are described in more detail according to Figure 2.

In an alternative, the analogue processing unit RF-FE1 may not comprise the analogue channel filter IFF. In such a case, a single filtering may be done by a digital filter DCF such as a digital channel filter of the digital processing unit DIG_BB1.

The digital baseband board DIG_BB1 comprises the digital channel filter DCF and a processing unit PU1 such as a CPU (CPU = central processing unit). Further components of the digital processing unit DIG_BB1 are not shown for simplification. The digital channel filter DCF may filter a single radio frequency channel or more than one radio frequency channel within a specific frequency band.

The automatic gain control circuit AGCC1 comprises the processing unit PU1, a digital-to-analogue converter D/A-C1, and an automatic gain control connection AGC_C1 to one or more components of the analogue processing unit RF-FE1. In on alternative, the automatic gain control circuit AGCC1 may comprise more than one digital-to-analogue converter and more than one automatic gain control connection.

The analogue interferer protection control circuit AIPCC comprises a coupler COUP (not shown in Figure 1 but in Figure 2), a measuring unit PD such as a power detector, and a controlling unit C such as a comparator. The coupler and the power detector PD are located between the input IN of the device DEV1 and the analogue channel filter IFF or the digital channel filter DCF.

The comparator C may comprise an integration function with a low-pass filtering effect to eliminate short-time fluctuations of an output signal of the power detector PD being applied to a first input port of the comparator C, An analogue threshold voltage ATV is applied to a second input of the comparator C. The analogue threshold voltage ATV may depend on a dynamic range of a single component or on dynamic ranges of several components being located between the input of the device DEV1 and the analogue channel filter IFF or the digital channel filter DCF.

The analogue threshold voltage ATV may be generated by a digital value, which is converter by a further digital-to-analogue converter. In an alternative, the analogue threshold voltage ATV may be directly generated via an adjustable voltage source.

The comparator C compares analogue data of the output signal of the power detector PD and of the analogue threshold voltage ATV. An output signal of the comparator C is applied to one or more components of the device DEV1 being located between the input IN of the device DEV1 and the analogue channel filter IFF or the digital channel filter DCF.

The comparator C controls the one or more components of the device DEV1 being located between the input IN and the analogue channel filter IFF or the digital channel fitter DCF depending on a power level of the radio frequency signals, which is measured by the power detector PD. If a voltage level of on output signal of the power detector PD exceeds the analogue threshold voltage ATA for example in case of in-bond interferers, the output signal of the comparator C lowers a power level of the radio frequency signals within the device DEV1 by controlling the one or more components, which is explained in more detail according to Figure 2.

Referring to Figure 2, the analogue processing unit RF-FE1 according to the first embodiment of the invention is shown in more detail,

The analogue processing unit RF-FE1 comprises a voltage-controlled variable attenuator VVA, the coupler COUP, an RF amplifler AMP, an amplifier LNA1 such as a low-noise amplifier, an RF filter RFF for attenuating out of bond signals additional to an attenuation of the band-pass filter BPF of the duplexer DUP, a mixer MIX such as a gain-controlled downconverting mixer, a local oscillator LO, the analogue channel filter IFF, and an I/Q demodulator I/Q-D such as a gain-controlled IF demodulator (IF = intermediate frequency)

In a first alternative, the analogue processing unit RF-FE1 may not comprise the RF filter RFF. In a further alternative, the analogue processing unit RF-FE1 may comprise a power amplifier instead of the RF filter RFF, the mixer MIX, the local oscillator LO, and the I/Q demodulator I/Q-D, if the device DEV1 may be a repeater and the received radio frequency signals RFS are retransmitted.

The amplifier LNA1, the mixer MIX, and the I/Q demodulator I/Q-D may be controlled by the automatic gain control circuit AGCC1 via the automatic gain control connection AGC-C1. In further alternatives, one component such as the amplifier LNA1, or two components such as the amplifier LNA1 and the mixer MIX may be controlled by the automatic gain control circuit AGC-GL

The analogue interferer protection control circuit AIPCC may comprise the coupler COUP, the RF amplifier AMP, the comparator C, a nd the voltage-controlled variable attenuator VVA between the input IN of the device DEV1 and the amplifier LNA1 of the analogue processing unit RF-FE1.

The voltage-controlled variable attenuator VVA attenuates the radio frequency signals RFS_DEV_IN depending on a power level of the radio frequency signals, which is measured by the power detector PD.

By using the first embodiment of the invention, on input power level of the amplifier LNA1 may be kept below a first predefined threshold to be able to operate the amplifier LNA1 within its dynamic range.

In an alternative, the input power level of the ampitfier LNA1 may be kept below the first predefined threshold to be able to operate the amplifier LNA1 and subsequent components such as the mixer MIX within its dynamic ranges.

According to the first embodiment of the invention, the automatic gain control circuit AGCC1 controls components LNA1, MIX, I/Q-D, which are different than the component VVA being controlled by the analogue interferer protection control circuit AIPCC.

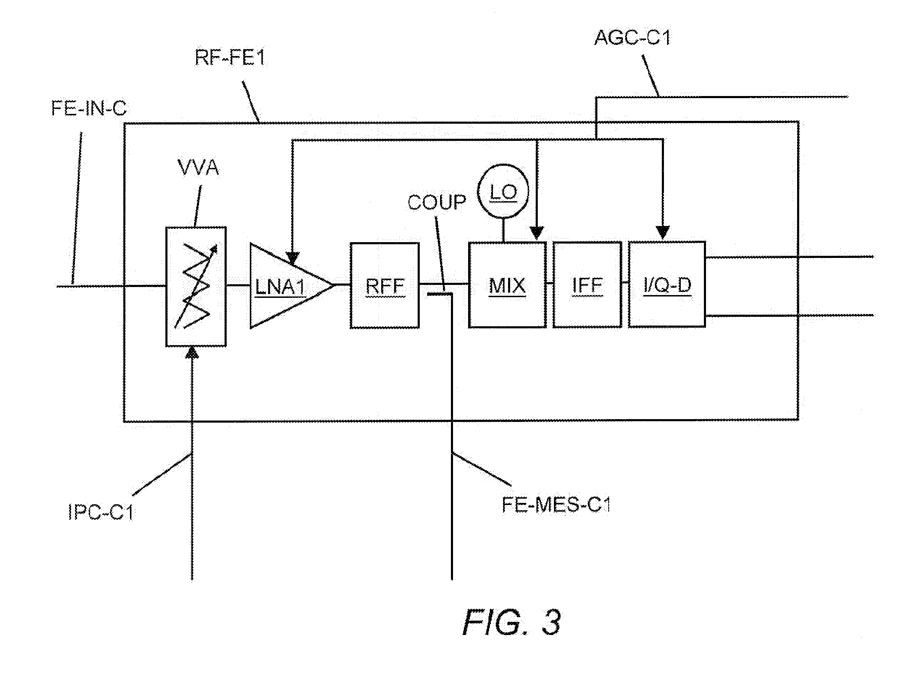

Referring to Figure 3, the analogue processing unit RF-FE1 is alternatively shown according to the second embodiment of the invention. The elements in Figure 3 that correspond to elements of Figure 2 have been designated by same reference numerals.

In comparison to the first embodiment of the invention, the coupler COUP of the analogue processing unit RF-FE1 is located between the RF filter RFF and the mixer MIX. This provides the advantage of coupling a part of already pre-amplified radio frequency signals to the analogue interfere protection control circuit AIPCC via the measuring connection FE-MES-C1 and not requiring the amplifier AMP as being used according to the first embodiment of the invention.

By using the second embodiment of the invention, the input power level of the amplifier LNA1 may be kept below a first predefined threshold to be able to operate the amplifier LNA1 within its dynamic range.

In an alternative, the input power level of the amplifier LNA1 may be kept below the first predefined threshold to be able to operate the amplifier LNA1 and subsequent components such as the mixer MIX within its dynamic ranges.

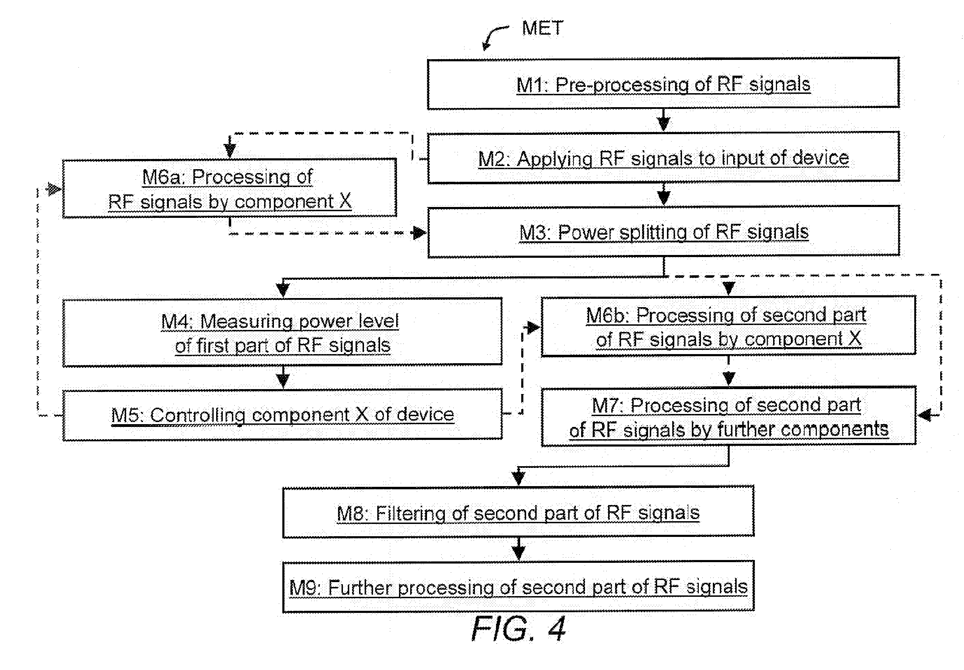

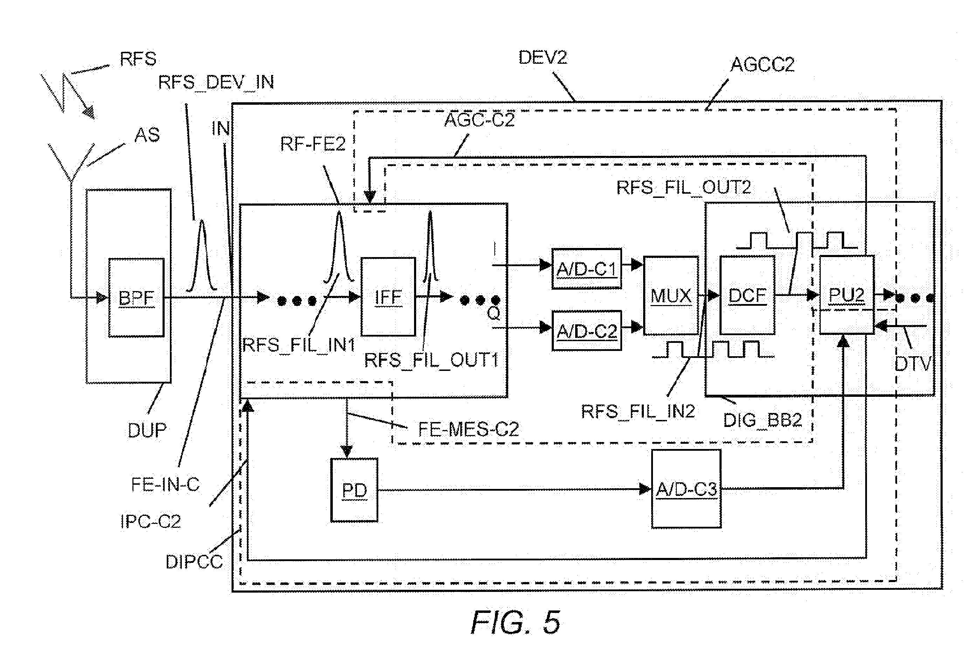

Referring to Figure 4, a block diagram of a method MET according to the embodiments of the invention is shown. The sequence and the number of the steps for performing the method MET is not critical, and as can be understood by those skilled in the art, that the sequence and the number of the steps may vary without departing from the scope of the invention. The method MET is described exemplarily according to the first embodiment of the invention but can be also used for embodiments of the invention described according to Figure 5 to Figure 11. Dashed lines in Figure 4 indicate, that a flow of the method MET varies depending on the embodiments of the invention.

In a first step M1, the radio frequency signals RFS may be pre-processed. According to the first embodiment of the invention, the radio frequency signals RFS are received via the antenna system AS and are filtered by the band-pass filter BPF of the duplexer DUP to get the radio frequency signals RFS_DEV_IN.

In a further step M2, the radio frequency signals RFS_DEV_IN are applied to an input IN of the device DEV1 via an input connection FE-IN-C.

In a next step M3, the coupler COUP splits a power level of radio frequency signals outputted by the voltage-controlled variable attenuator VVA in a first part, which is applied to the RF amplifier AMP and a second part, which is applied to the amplifier LNA1.

The first part of the radio frequency signals is amplified by the RF amplifier AMP and is outputted to a measuring connection FE-MES-C1. In an alternative, the analogue processing unit RF-FE1 does not comprise the RF amplifier AMP, if for example a sensitivity of the power detector PD allows detecting also radio frequency signals, which are not pre-amplified by the RF amplifier AMP.

In a further step M4, a power level of the first part of the radio frequency signals is measured by the power detector PD.

In a next step M5, a component X such as the voltage-controlled variable attenuator VVA is controlled via an interferer protection control connection IPC-C1 by the comparator C of the analogue interferer protection control circuit AIPCC depending on a difference voltage between a voltage of the output signal of the power detector PD and the analogue threshold voltage ATV.

If the in-band interferer is received via the antenna system AS with frequency components outside the frequency range of the analogue channel filter IFF and the digital channel filter DCF and inside the frequency bandwidth of the band-pass filter BPF, an increased power level of the received radio frequency signals RFS is detected by the power detector PD, which increases of on overall voltage of the output signal of the power detector-PD.

If for example the overall voltage is higher than the analogue threshold voltage ATV, a difference between the overall voltage and the analogue threshold voltage ATV increases and an output voltage of the output signal of the comparator C rises, Thereby, the attenuation of the voltage-controlled variable attenuator VVA increases until the overall voltage is equal to the analogue threshold voltage ATV.

In parallel to the steps M4 and M5 and either in a further step M6a or an even further step M6b, the second part of the radio frequency signals are processed by the component X, which is control led by the step M5. According to the first embodiment of the invention, the second part of the radio frequency signals may be attenuated in the further step M6a by the voltage-variable attenuator VVA in case of high power interferers and the even further step M6b is not used.

In parallel to the steps M4 and M5 and after the further step M6a (or the even further step M6b) in a next step M7, the second part of the radio frequency signals are processed by further components such as the amplifier LNA1, the RF filter RFF, and the mixer MIX as being used in a superheterodyne radio receiver.

In the further step M8, the second part of radio frequency signals RFS_FIL_IN1 may be filtered by the analogue channel filter IFF comprising a specific frequency channel location and can analogue frequency channel bandwidth and may be outputted as radio frequency signals RFS__FIL_OUT1.

In a next step M9, the second pan of the radio frequency signals RFS_FIL_OUT1 are further processed by components of the device DEV1 such as the I/Q demodulator for splitting the radio frequency signals into two frequency parts I, Q, the two analogue-to-digital converters A/D-C1, A/D-C2, the digital multiplexer MUX generating digital radio frequency signals RFS_FIL_IN2, the digital channel filter DCF, and the processing unit PU1.

The digital channel filter DCF comprising the specific frequency channel location and a digital frequency channel bandwidth outputs radio frequency signals RFS_FIL_OUT2 and blocks remaining frequency components, which could not be blocked by the analogue channel filter IFF.

The processing unit PU1 of the automatic gain control circuit AGCC1 measures a power level of the digital radio frequency signals RFS_FIL_OUT2. Depending on the power level, the processing unit PU1 outputs three digital control signals according to the first embodiment of the invention. The digital-to-analogue converter D/A-C1 converts the three digital control signals into three analogue control signals, which are applied to the amplifier LNA1, the mixer MIX, and the I/Q demodulator I/Q-D of the analogue processing unit RF-FE1 via the first control connection ARC-C1. Therewith, gain values of the amplifier LNA1, the mixer MIX, and the I/Q demodulator I/Q-D can be adjusted depending on the power level of the digital radio frequency signals RFS_FIL_OUT2 and in-band interferers with frequency components inside the analogue frequency bandwidth of the analogue channel filter IFF and the digital frequency bandwidth of the digital channel filter DCF can be attenuated by the automatic gain control circuit AGCC1.

However, the automatic gain control circuit AGCC1 cannot handle the in-band interferers with frequency components outside pass-bands of the analogue channel filter IFF and the digital frequency bandwidth of the digital channel filter DCF and inside a pass-band of the band-pass filter BPF. Therefore, components of the analogue processing unit RF-FE1 located between the input IN of the device DEV1 and the analogue channel filter IFF may process the radio frequency signals RFS_DEV_IN with a power level above a dynamic range of one or more of the components. Saturation effects at one or more of the components with degrading SNR values of the radio frequency signals RFS_FIL_IN would be a result. To avoid the saturation effects, the analogue interferer protection control circuit AIPCC is used. Thereby, a power level of the radio frequency signals can be kept within a dynamic range of a single component such as the amplifier LNA1 or within dynamic ranges of several components being located between the input of the device DEV1 and the analogue channel filter IFF or the digital channel filter DCF.

Referring to Figure 5, a block diagram of a device DEV2, the antenna system AS, and the duplexer DUP according to a third, a fourth, a fifth, and a sixth embodiment of the invention is shown. The elements in Figure 5 that correspond to element of Figure 1 have been designated by same reference numerals.

In comparison to the first and the second embodiment of the invention, an automatic gain control circuit AGCC2 comprises a controlling and processing unit PU2 such as a CPU and no digital-to-analogue converter. Thereby, a first digital control signal of the controlling and processing unit PU2 is applied directly via an automatic gain control connection AGC-C2 to one or more components of an analogue processing unit RF-FE2 such as an RF front-end.

Furthermore in comparison to the first and the second embodiment of the invention, a digital interferer protection circuit DIPCC instead of an analogue inteferer protection circuit is used, which comprises the power detector PD, a further anatogue-to-digital converter A/D-C3, and the controlling and processing unit PU2 of digital processing unit DIB_BB2 such as a digital baseband board.

The output signal of the power detector PD is applied to an input of the further analogue-to-digital converter A/D-C3. An output signal of the further analoque-to-digital converter A/D-C3 is applied to an input of the controlling and processing unit PU2.

A digital threshold voltage DTV is further applied to the controlling and processing unit PU2. The digital threshold voltage DTV may depend on a dynamic range of one or more components being located between the input IN of the device DEV2 and the anologue channel filter IFF or the digital channel filter DCF.

The digital threshold voltage DTV may be stored on storing means of the digital processing unit DIG_BB2 such as a hard disk or a read-only memory.

The controlling and processing unit PU2 controls the one or more components of the device DEV2 being located between the input IN and the analogue channel filter IFF or the digital channel filter DCF depending on a power level of the radio frequency signals, which is measured by the power detector PD, Thereby, the controlling and processing unit PU2 compares digital data of the output signal of the further analogur-to-digital converter A/D-C3 and of the digital threshold voltage DTV. If for example a digital value of the output signal of the further analogue-to-digital converter A/D-C3 exceeds a value of the digital threshold voltage DTV due to in-bond interferers, a difference between the two values is detected and a second digital control signal is applied by the controlling and processing unit PU2 via an interferer protection circuit connection IPC-C2 to one or more components between the input IN of the device DEV2 and the analogue channel filter IFF or the digital channel filter DCF.

The second control signal may be applied directly to a digital control port of the one or more components via the interferer protection circuit connection IPC-C2. In an alternative, the second control signal may be applied via one or more digital-to-analogue converters to an analogue control port of the one or more components via the interferer protection circuit connection IPC-C2.

The second control signal may be applied or changed until the value of the output signal of the further analogue-to-digital converter A/D-C3 is equal to the value of the digital threshold voltage ATV.

Thereby, a power level of the radio frequency signals can be kept within a dynamic range of a single component or within dynamic ranges of several components of the device DEV2 being located between the input IN of the device DEV2 and the analogue channel filter IFF or the digital channel filter DCF.

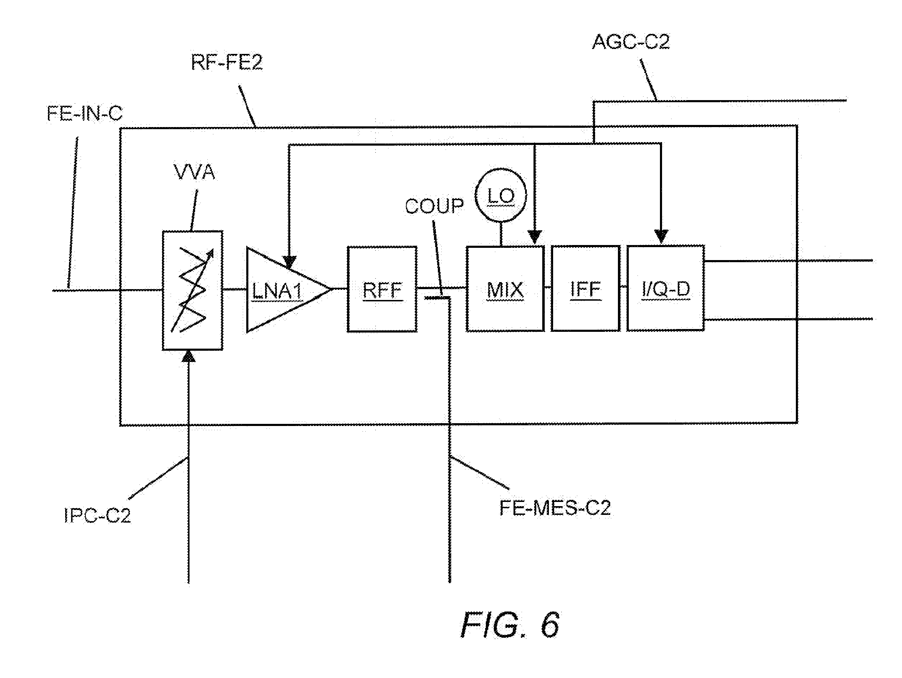

Referring to Figure 6, the analogue processing unit RF-FE2 according to the third embodiment of the invention is shown in more detail. The elements in Figure 6 that correspond to elements of Figure 3 have been designated by same reference numerals.

The only differences of the third embodiment of the invention in comparison to the second embodiment of the invention are using the automatic gain control circuit AGCC2 and digital control ports at the components of the analogue processing unit RF-FE2 instead of using the automatic gain control circuit AGCC1 and analogue control ports at the components of the analogue processing unit RF-FE1 and using the digital interferer protection circuit DIPCC instead of the analogue interferer protection control circuit AIPCC.

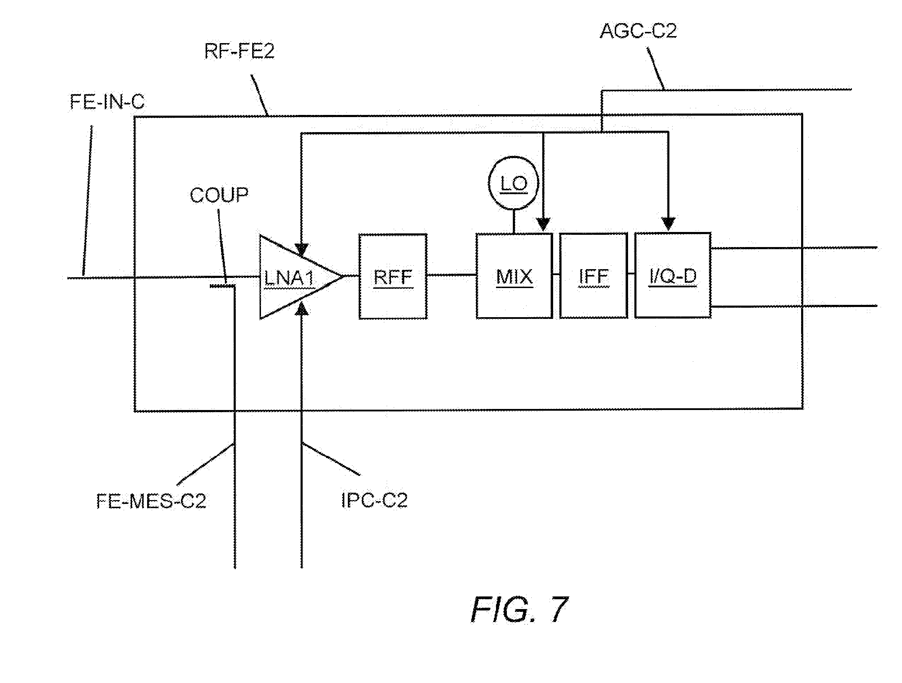

Referring to Figure 7, the analogue processing unit RF-FE2 according to the fourth embodiment of the invention is shown in more detail. The elements in Figure 7 that correspond to elements of Figure 2, Figure 3 or Figure 6 have been designated by same reference numerals.

In comparison to the third embodiment of the invention, a voltage-controlled variable attenuator is not used and the coupler COUP is located in front of an input of the amplifier LNA1.

The amplifier LNA1 is controlled via the first digital control signal of the processing unit PU2 being applied via the automatic gain control connection AGC-C2 depending on a power level of the radio frequency signals measured at the output of the digital channel filter DCF and via the second digital control signal of the processing unit PU2 being applied via the interferer protection circuit connection IPC-C2 depending on a power level of the radio frequency signals, which is measured by the power detector PD.

The first and the second digital control signal of the processing unit PU2 may be applied to control a gain of the amplifier LNA1 for example in the following way: The gain of the amplifier LNA1 will be primarily controlled via the automatic gain control connection AGC-C2. If an enhanced power level is measured by the power detector PD because of in-band interferers and if a gain control value of the second control signal of the processing unit PU2 is below a gain control value of the first control signal of the processing unit PU2, the gain control value of the second digital control signal will be used to control the gain of the amplifier LNA1.

By using the fourth embodiment of the invention, an output power level of the amplifier LNA1 can be kept below a second predefined threshold to operate a subsequent component such as the mixer MIX within its dynamic range or several subsequent components within its dynamic ranges.

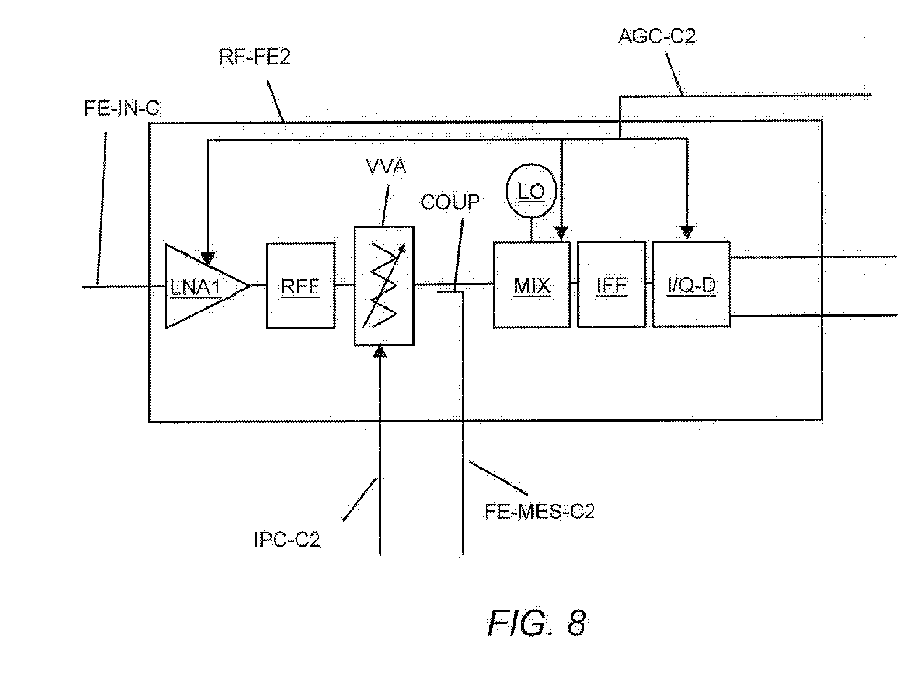

Referring to Figure 8, the analogue processing unit RF-FE2 according to a fifth embodiment of the invention is shown. The elements in Figure 8 that correspond to elements of Figure 2, Figure 3, Figure 6, or Figure 7 have been designated by same reference numerals.

In comparison to the second embodiment of the invention and instead of an input power control of the amplifier LNA1, an input power of the mixer MIX is controlled depending on a power level of the radio frequency signals coupled by the coupler COUP to the measuring connection FE-MES-C2. The voltage-controlled variable attenuator VVA and the coupler COUP are located between the RF filter RFF and the mixer MIX. The fifth embodiment of the invention may be used, if the amplifier LNA1 is less susceptible than the mixer MIX to the in-band interferers with frequency components outside the frequency bandwidth of the analogue channel filter IFF and the digital channel filter DCF but inside the frequency bandwidth of the band-pass filter BPF.

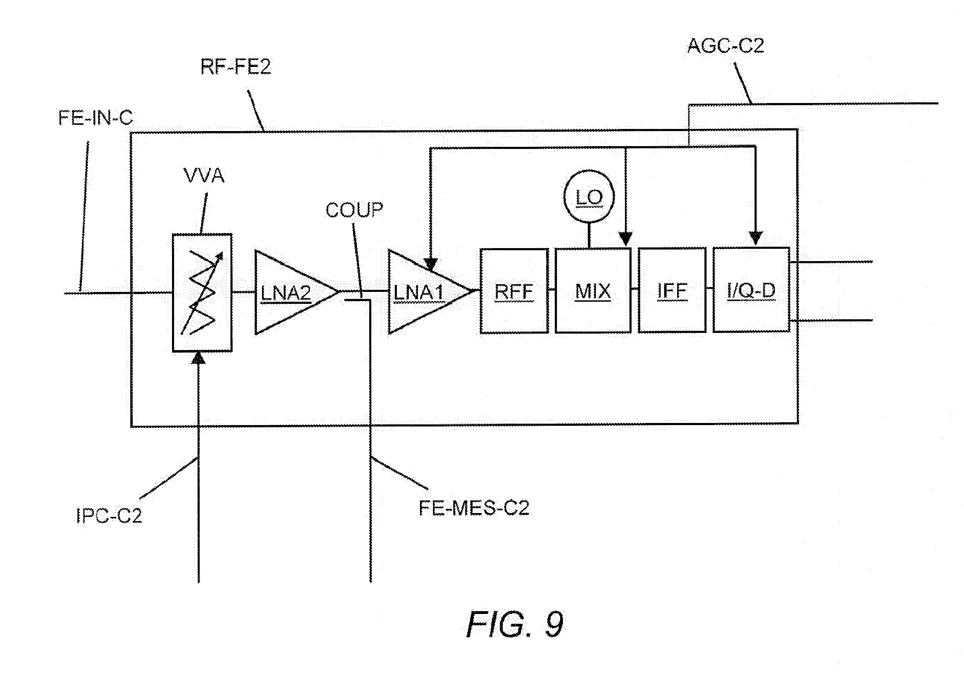

Referring to Figure 9, the analogue processing unit RF-FE2 according to the sixth embodiment of the invention is shown. The elements in Figure 9 that correspond to elements of Figure 2, Figure 3, or Figure 6 to Figure 8 have been designated by same reference numerals.

In comparison to the second embodiment of the invention, a further amplifier LNA2 such as a further low-noise amplifier is used in the propagation path of the radio frequency signals. The further amplifier LNA2 may be located in front of the input of the amplifier LMA1. The voltage-controlled variable attenuator VVA is located in front of the further amplifier LNA2 and the coupler COUP is located between the further amplifier LNA2 and the amplifier LNA1.

Thereby, the sixth embodiment of the invention uses a two-stage amplification in the analogue processing unit RF-FE2. A first stage of the two-stage amplification is controlled by the digital interferer protection control circuit DIPCC via the interferer protection control connection IPC-C2 for blocking in-band interferers with frequency components outside the pass-band of the analogue channel filter IFF and the digital channel filter DCF but inside the pass-band of the band-pass filter BPF and depending on a power level of the radio frequency signals coupled by the coupler COUP to the measuring connection FE-MES-C2. A second stage of the two-stage amplification is controlled by the automatic gain control circuit AGCC2 for optimizing a power level of the radio frequency signals RFS according to dynamic ranges of the amplifier LNA1, the mixer MIX, and the I/Q demodulator I/Q-D.

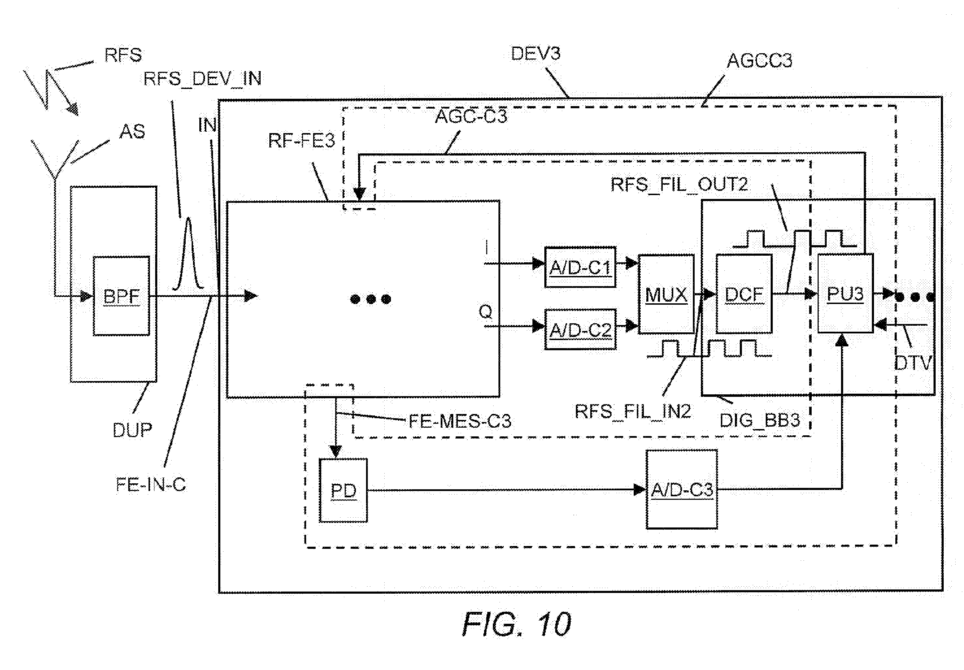

Referring to Figure 10, a block diagram of a device DEV3, the antenna system AS, and the duplexer DUP according to a seventh embodiment of the invention is shown. The elements in Figure 6 that correspond to elements of Figure 1 or Figure 5 have been designated by same reference numerals.

In comparison to the first to sixth embodiment of the invention, an analogue processing unit RF-FE3 does not comprise the analogue channel filter IFF. A specific channel will be selected by the digital channel filter DCF. An automatic gain control circuit AGCC3 of the device DEV3 comprises a controlling and processing unit PU3, the power defector PD, and the further analogue-to-digital converter A/D-C3.

The controlling and processing unit PU3 controls the one or more components of the device DEV3 being located between the input IN and the digital channel filter DCF depending on a power level of the radio frequency signals, which is measured by the power detector PD.

Thereby, a digital control signal of the controlling and processing unit PU3 of a digital processing unit DIG_BB3 such as a digital baseband board is applied via an automatic gain control connection AGC-C3 to one or more components being located between the input IN and the digital channel filter DCF of the device DEV3.

The digital control signal according to the seventh embodiment of the invention depends not only on the power level of the filtered radio frequency signals RFS_FIL_OUT2 but also on the power level of the radio frequency signals between the input IN of the device DEV3 and the digital channel filter DCF.

Thereby, an additional and independent digital interferer protection circuit can be avoided.

The automatic gain control circuit AGCC3 may firstly adapt the power level of the radio frequency signals according to dynamic ranges of the components of the device DEV3 in case of in-band interferers being detected via the power detector PD and secondly adapts the power level of the radio frequency signals according to dynamic ranges of the components of the device DEV3 in case of no in-band interferers via the controlling and processing unit PU3 based on measurements of the power level of the filtered radio frequency signals RFS_FIL_OUT2.

Alternatively, the automatic gain control circuit AGCC3 may check first the power level of the filtered radio frequency signals PFS_FIL_OUT2 according to in-band interferers (passed by the digital channel filter DCF). Then, the automatic gain control circuit AGCC3 may check, if there is an additional power level related to in-band interferers (blocked by the digital channel filter DCF) and adapts the power level of the radio frequency signals by controlling one or more components via the automatic gain control connection AGC-C3 accordingly.

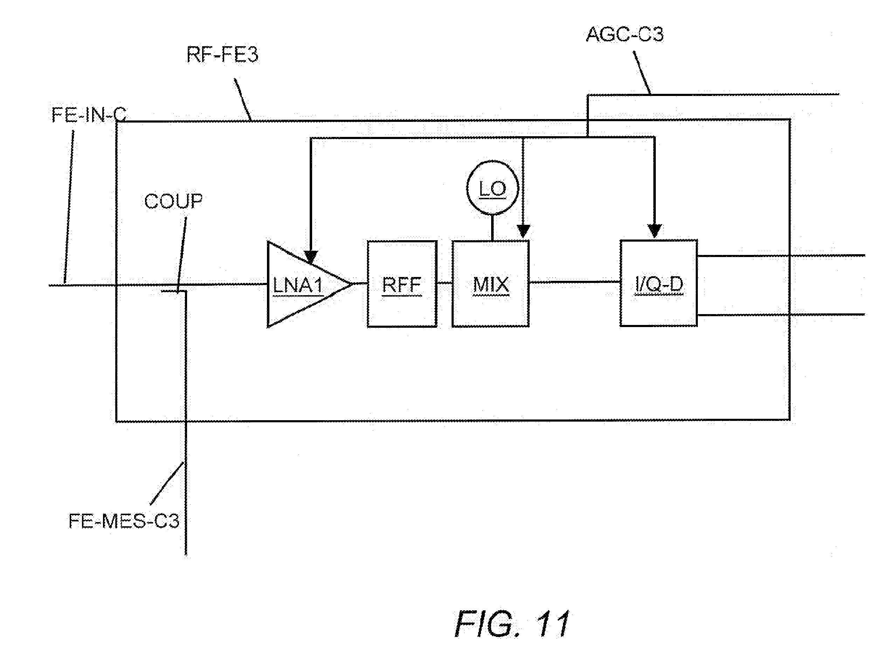

Referring to Figure 11, the analogue processing unit RF-FE3 according to the seventh embodiment of the invention is shown in more detail. The elements in Figure 11 that correspond to elements of Figure 2, Figure 3, or Figure 6 to Figure 9 have been designated by same reference numerals. In comparison to the previous embodiments of the invention, no additional analogue or digital interferer protection control circuit with an interferer protection control connection is used. The gain of the amplifier LNA1, of the mixer MIX, and of the I/Q demodulator I/Q-D is controlled by the automatic gain control circuit AGC-C3 and applied via the automatic gain control connection AGC-C3.

Especially in comparison to the fourth embodiment of the invention, no two control signals are applied to the amplifier LNA1.

Similar to the fourth embodiment of the invention, the coupler COUP is located in front of the amplifier LNA1 and couples the second part of the radio frequency signals to a measuring connection FE-MES-C3.

The seventh embodiment of the invention provides the advantage of requiring only one control connection between the processing unit PU3 and the analogue processing unit RF-FE3.

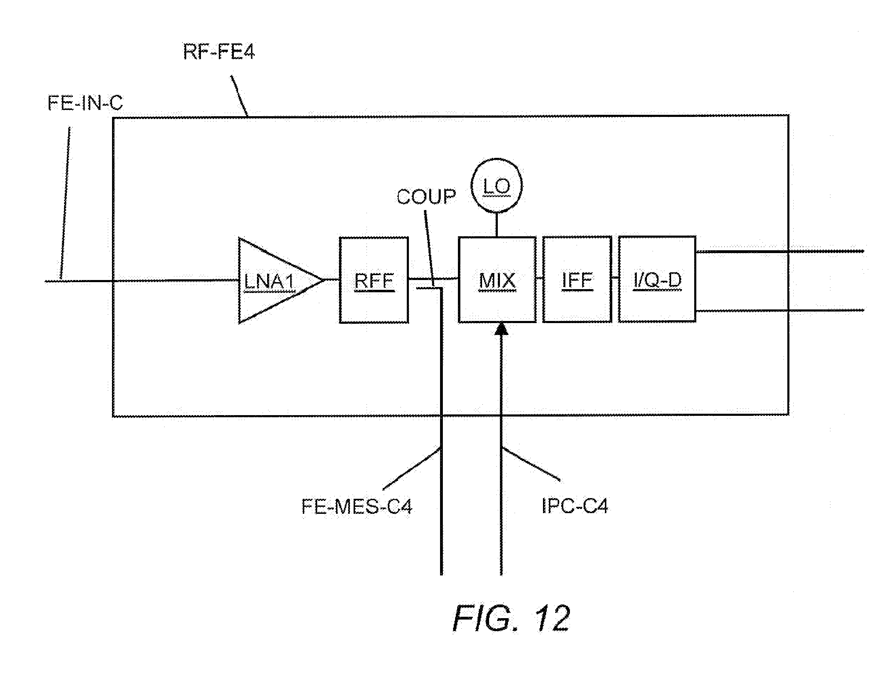

Referring to Figure 12, an analogue processing unit RF-FE4 according to an eighth embodiment of the invention is shown. The elements in Figure 12 that correspond to elements of Figure 2, Figure 3, Figure 6 to Figure 9, or Figure 11 have been designated by same reference numerals. According to the eighth embodiment of the invention, no automatic gain control circuit may be used for controlling components of the analogue processing unit RF-FE4.

In comparison to the analogue processing unit RF-FE1 of Figure 2, the coupler COUP is located between the RF filter RFF and the mixer MIX and no voliage-controlled variable attenuator and no RF amplifier in a measuring connection FE-MES-C4 of the analogue processing unit RF-FE4 is used.

The gain of the mixer MIX is controlled via an interferer protection control connection IPC-C4 of an analogue or digital interferer protection circuit depending on a power level of the radio frequency signals coupled by the coupler COUP to the measuring connection FE-MES-C4. Thereby, the power level of the radio frequency signals can kept within the dynamic range of the mixer MIX.

The eighth embodiment of the invention may be used, if the amplifier LNA1 is less susceptible than the mixer MIX to the in-band interferers with frequency components outside the frequency bandwidth of the analogue channel filter IFF and the digital channel filter DCF but inside the frequency bandwidth of the band-pass filter BPF.

Depending on a type of control signals (analogue or digital) applied via control connections IPC-C1, IPC-C2, AGC-C1, AGC-C2, AGC-C3 and a type of control port (analogue or digital) of a component to be controlled, an analogue-to-digital converter or a digital-to-anaologue converter may be required between the processing unit PU1, PU2, PU3 and the component or between the comparator C and the component. Such analogue-to-digital converters or digital-to-analogue converters are not shown in Figures 1 to 3 and 5 to 12 for simplification.

The invention is not limited to an application of a single embodiment but also can be used for a combination of several of the embodiments such as using for example an input power control of the amplifier LMA1 by a first analogue interferer protection control circuit and an input power control of the mixer MIX by a second analogue interferer protection control circuit.

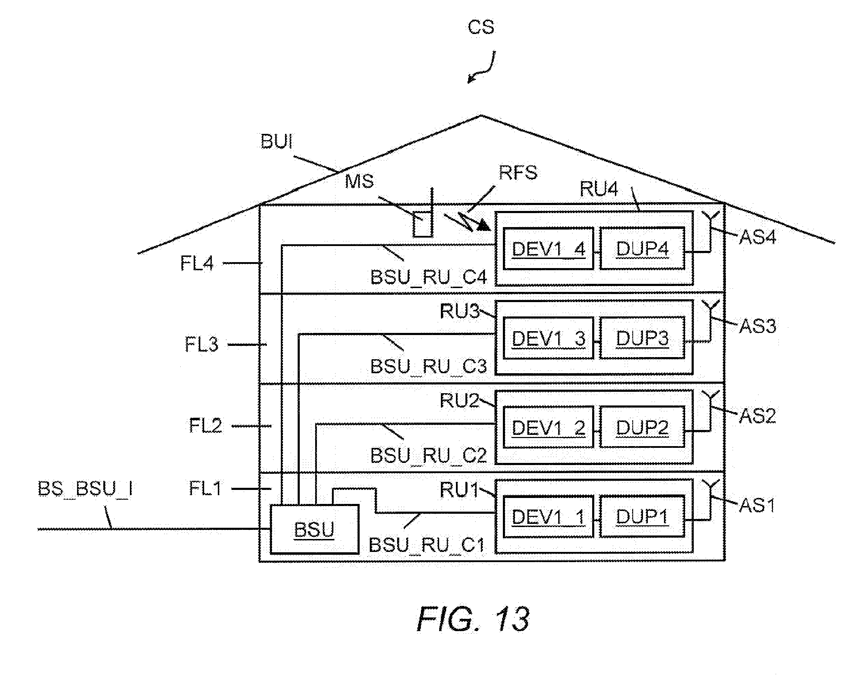

Referring to Figure 13, a communication system CS according to an application of the embodiments of the invention is shown schematically. The communication system CS may be an indoor radio communication system with an interface BS_BSU_I to a wide-area radio communication system such as a UMTS radio communication system (UMTS = Universal Mobile Telecommunications System). In an alternative, the communication system CS may be a wide-area radio communication system such as a GSM/GPRS radio communication system (GSM = Global system for Mobile communications, GPRS = General Packet Radio Service) or a wireless local area network such as an IEEE 802.11 network.

The communication system CS is located in a building BUI. In further alternatives, the communication system CS may be located in a road funnel or a railway funnel.

The interface BS_BSU_I connects a base station such as a Node B to a base station unit BSU of the communication system CS. The communication system CS comprises remote units RU1, RU2, RU3, RU4, which are connected to the base station unit BSU via connections BSU_RU_C1, BSU_RU_C2, BSU_RU_C3, BSU_RU_C4. Further remote units are not shown for simplification. The connections BSU_RU_C1, BSU_RU_C2, BSU_RU_C3, BSU_RU_C4 may belong to an Ethernet distribution network within the building BUI.

The remote units RU1, RU2, RU3, RU4 may comprise devices DEV1_1, DEV1_2, DEV1_3, DEV1_4 for example according to the first embodiment of the invention and duplexers DUP1, DUP2, DUP3, DUP4.

In an alternative, the remote units RU1, RU2, RU3, RU4 may comprise devices according to the other embodiments of the invention.

The remote units RU1, RU2, RU3, RU4 are connected to antenna systems AS1, AS2, AS3, AS4.

Each of the remote units RU1, RU2, RU3, RU4 is located on a different one of floors FL1, FL2, FL3, FL4 of the building BUI. In further alternatives, more than one remote unit is located on the floors FL1, FL2, FL3, FL4 of the building BUI or a remote unit is located only on every second floor.

The base station unit BSU broadcasts downlink signals coming from the base station to all remote units RU1, RU2, RU3, RU4 of the communication system CS. The remote units RU1, RU2, RU3, RU4 transmit the broadcasted downlink signals to a mobile station MS being located in the building BUI. Further mobile stations are not shown for simplification.

In uplink direction, radio frequency signals RFS transmitted by the mobile station MS are received by one or more of the remote units RU1, RU2, RU3, RU4, are transmitted to the base station unit BSU and are summed by the base station unit BSU to a single stream, which is forwarded by the base station unit BSU via the interface BS_BSU_1 to the base station. In an alternative, a remote unit may sum the radio frequency signals RFS received by more than one remote unit and forwards the radio frequency signals in a single stream to the base station unit BSU.

If radio frequency signals of an in-band interferer outside the pass-band of the analogue channel filter IFF and the digital channel DCF but inside the pass-band of the band-pass filter BPF are received by one or more of the remote units RU1, RU2, RU3, RU4 and the invention would not be applied, a signal-to-noise ratio of the radio frequency signals within the one or more remote units RU1, RU2, RU3, RU4 would be deteriorated because of saturation effects in one or more components of the one or more remote units RU1, RU2, RU3, RU4. By a summation process in the base station unit BSU the signal-to-noise ratio of the radio frequency signals within the one or more remote units RU1, RU2, RU3, RU4 would dominate an overall signal-to-noise ratio of summed radio frequency signals.

By using the invention, a power level of the received radio frequency signals of the one or more of the remote units RU1, RU2, RU3, RU4 is lowered and the signal-to-noise ratio of the received radio frequency signals will not be deteriorated by saturation effects in one or more of the remote units RU1, RU2, RU3, RU4. Thereby, a contribution of the received radio frequency signals of the one or more of the remote units RU1, RU2, RU3, RU4 for the summation is lowered, and the overall signal-to-noise ratio of the summed radio frequency signals is not changed by a signal-to-noise ratio of interfered received radio frequency signals of the one or more of the remote units RU1, RU2, RU3, RU4.

## Claims

1. A device (DEV1, DEV2, DEV3) for processing band-restricted radio frequency signal comprising an input (IN) for said radio frequency signals (RFS_DEV_IN) and at least one filter (IFF, DCF) for filtering said radio frequency signals (RFS_FIL_IN1, RFS_FIL_IN2), wherein said device (DEV1, DEV2, DEV3) further comprises:
- at least one measuring unit (PD) for measuring at least one power level of said radio frequency signals between said input (IN) and said at least one filter (IFF, DCF), and
- a first controlling unit (C, PU2, PU3) for controlling at least one first component of said device (DEV1, DEV2, DEV3) between said input (IN) and said at least one filter (IFF, DCF) depending on said at least one power level.

2. Device (DEV3) according to claim 1, wherein said first controlling unit (PU3) for controlling said at least one first component of said device (DEV3) further depending on a power level of filtered radio frequency signals (RFS_FIL_OUT2).

3. Device (DEV1, DEV2) according to claim 1, wherein said device (DEV1, DEV2) further comprising at least one second controlling unit (C, PU2) for controlling at least one second component of said device (DEV1, DEV2).

4. Device (DEV1, DEV2) according to claim 3, wherein said at least one second controlling unit (C, PU2) for controlling said at least one second component of said device (DEV1, DEV2) comprises an automatic gain control depending on a power level of filtered radio frequency signals (RFS_FIL_OUT2).

5. Device (DEV1, DEV2, DEV3) according to any of the preceding claims, wherein said first controlling unit (C, PU2, PU3) for controlling said at least one first component of said device (DEV1, DEV2, DEV3) adjusts an input power level of an amplifier (LNAl) or a gain of said amplifier (LNA1).

6. Device (DEV1, DEV2, DEV3) according to claim 5, wherein said amplifier (LNA1) is a low- noise amplifier.

7. Device (DEV1, DEV2, DEV3) according to any of the preceding claims, wherein said first controlling unit (C, PU2, PU3) for controlling said at least one first component of said device (DEV1, DEV2, DEV3) adjusts an input power level of a mixer (MIX) or a gain of said mixer (MIX).

8. Device (DEV1, DEV2, DEV3) according to claim 7, wherein said mixer (MIX) is a down-converting mixer.

9. Device (DEV1) according to any of the preceding claims, wherein said first controlling unit (C) for controlling said at least one first component of said device (DEV1) comprises an analogue data comparison.

10. Device (DEV2, DEV3) according to any of the claims 1 to 8, wherein said first controlling unit (PU2, PU3) for controlling said at least one first component of said device (DEV2, DEV3) comprises a digital data comparison.

11. Device (DEV1, DEV2, DEV3) according to any of the preceding claims, wherein said device (DEV1, DEV2, DEV3) further comprises at least one coupler (COUP) between said input (IN) and said at least one filter (IFF, DCF) and wherein said at least one measuring unit (PD) is at least one power detector connected to said coupler (COUP).

12. A receiver (RU1, RU2, RU3, RU4) comprising at least one device
(DEV1_1, DEV1_2, DEV1_3, DEV1_4) according to any of the preceding claims.

13. A system (CS) comprising at least one receiver (RU1, RU2, RU3, RU4) according to claim 12.

14. System (CS) according to claim 13, wherein said system (CS) is an in-building communication system.

15. A method (MET) for processing radio frequency signals (RFS) comprising the steps of:
- applying (M2) said radio frequency signals (RFS_DEV_IN) to an input (IN) of a device (DEV1, DEV2, DEV3), and
- filtering (M8) said radio frequency signals (RFS_FIL_IN1, RFS__FIL_IN2) by said device (DEV1, DEV2, DEV3),
wherein said method (MET) further comprising the steps of:
- measuring (M4) at least one power level of said radio frequency signals between said step of applying (M2) said radio frequency signals to said input (IN) and said step of filtering (M8) said radio frequency signals (RFS_FIL_IN-1, RFS_FIL_IN2), and
- controlling (M5) at least one first component of said device (DEV1, DEV2, DEV3) between said step of applying (M2) said radio frequency signals (RFS_DEV_IN) to said input (IN) and said step of filtering (M8) said radio frequency signal (RFS_FIL_IN1, RFS_FIL_IN2) depending on said at least one power level.
